# EUROPÄISCHE PATENTSCHRIFT

(11) **EP 2 884 204 B1**
(45) Veröffentlichungstag und Bekanntmachung des Hinweises auf die Patenterteilung: **28.10.2020**
(21) Anmeldenummer: 14191552.0
(22) Anmeldetag: 03.11.2014
(51) Int. Cl.: F25B 30/02, F25B 49/00, F25B 31/00, F25B 40/06, F25B 41/04, F25B 49/02, H05K 7/20

(54) **Wärmepumpe mit einem kältemittelgekühlten Inverter**
Heat pump with an inverter cooled by coolant
Pompe à chaleur dotée d'un onduleur refroidi par fluide frigorigène

(30) Priorität: 10.12.2013 DE 102013225450
(43) Veröffentlichungstag der Anmeldung: 17.06.2015
(73) Patentinhaber: Robert Bosch GmbH, 70442 Stuttgart (DE)
(72) Erfinder: Kilast, Bernd, 71277 Rutesheim (DE)

(56) Entgegenhaltungen:
- EP-A2- 1 037 001
- US-A- 6 032 472
- US-A1- 2003 041 607
- US-A1- 2007 186 581

## Beschreibung

### Stand der Technik

Die Erfindung betrifft eine Wärmepumpe. Die Wärmepumpe weist einen Verdichter und einen elektronisch kommutierten Elektromotor zum Antrieb des Verdichters auf, welcher mit dem Verdichter verbunden ist. Die Wärmepumpe weist auch eine mit dem Elektromotor verbundene Leistungsendstufe, insbesondere Inverter auf, wobei die Leistungsendstufe ausgebildet ist, den Elektromotor - insbesondere zum Erzeugen eines magnetischen Drehfeldes - zu bestromen. Die Leistungsendstufe ist mit einem Abschnitt eines Kältemittelkreislaufs der Wärmepumpe wärmeleitend verbunden, sodass von der Leistungsendstufe erzeugte Verlustwärme an den Kältemittelkreislauf abgegeben werden kann.

In der US 2003/041607 A1 ist eine Klimaanlage beschrieben, die einen Klimakompressor, einen Elektronmotor und einen Kältemittelkreislauf umfasst, und insbesondere für Kraftfahrzeuge geeignet ist. Zur Kühlung der Steuereinrichtung des Elektromotors ist diese über verschiedene, im Kältemittelkreislauf angeordnete Ventile (Expansionsorgane) an den Kältemittelkreislauf angebunden, wobei eines der Ventile abhängig von der Temperatur der Steuereinrichtung gesteuert wird.

Bei Wärmepumpen, deren Leistungselektronik umfassend eine Leistungsendstufe von dem Kältemittelkreislauf der Wärmepumpe gekühlt wird, kann es beim Anlaufen des Verdichters, oder beim Betrieb mit durch die Leistungselektronik erzeugte geringe Verlustleistung vorkommen, dass die Temperatur der Leistungselektronik unter eine Umgebungstemperatur fällt, und die Leistungselektronik durch aus der Umgebung kondensierende Luftfeuchtigkeit betaut werden kann. Diese Betauung kann zu einem Ausfall der Leistungselektronik führen.

### Offenbarung der Erfindung

Eine Wärmepumpe gemäß der Erfindung ist in Anspruch 1 definiert. Erfindungsgemäß weist die Wärmepumpe wenigstens einen Temperatursensor und optional außerdem wenigstens einen Feuchtigkeitssensor auf. Der Temperatursensor ist angeordnet, eine Temperatur der Leistungsendstufe zu erfassen und ein die Temperatur repräsentierendes Temperatursignal zu erzeugen. Der Feuchtigkeitssensor ist ausgebildet, eine Luftfeuchtigkeit im Bereich der Leistungsendstufe zu erfassen und ein die Luftfeuchtigkeit repräsentierendes Feuchtigkeitssignal zu erzeugen. Der Kältemittelkreislauf weist eine Bypass-Fluidleitung und wenigstens ein steuerbar ausgebildetes Ventil auf. Die Bypass-Fluidleitung ist ausgebildet, einen Kältemittelfluss an dem mit der Leistungsendstufe verbundenen Abschnitt vorbeizuführen. Das Ventil ist ausgebildet, in Abhängigkeit eines Steuersignals den Kältemittelfluss durch den Abschnitt freizugeben oder zu sperren. Die Wärmepumpe weist eine mit dem Temperatursensor verbundene Steuereinheit auf, welche ausgebildet ist, das Steuersignal in Abhängigkeit des Temperatursignals und/oder des Feuchtigkeitssignals zu erzeugen.

Durch die so ausgebildete Wärmepumpe, insbesondere die Bypass-Fluidleitung und das wenigstens eine steuerbar ausgebildete Ventil kann vorteilhaft ein Unterkühlen der Leistungselektronik, insbesondere der Leistungsendstufe, und so ein Betauen der Leistungselektronik verhindert werden. Wenn beispielsweise die Temperatur der Leistungselektronik, erfasst durch den Temperatursensor, einen vorbestimmten Temperaturwert unterschreitet, so kann die Steuereinheit das Steuersignal erzeugen und so das Ventil zum Sperren des Abschnitts des Kältekreislaufs, insbesondere einer Fluidleitung des Kältekreislaufs, welcher wärmeleitend mit der Leistungselektronik wirkverbunden ist, ansteuern.

Bevorzugt ist der Abschnitt durch einen Kühlkörper, insbesondere einen Aluminiumblock gebildet. Der Kühlkörper weist wenigstens einen Fluidkanal zum Führen von Kältemittel auf, und ist ausgebildet, mit der Leistungsendstufe wärmeleitend, bevorzugt mittels einer Wärmeleitpaste, verbunden zu werden.

Bevorzugt ist das Ventil ein Magnetventil, welches einen elektromagnetisch bewegbar ausgebildeten Anker aufweist, welcher ausgebildet ist, den Kältemittelkreislauf bevorzugt in Abhängigkeit des Steuersignals zu unterbrechen und/oder freizugeben. Mittels des Magnetventils kann so vorteilhaft das durch den Abschnitt des Kältekreislaufs, welcher ausgebildet ist, die Leistungsendstufe zu kühlen, fließende Kühlfluid mittels eines Steuersignals steuerbar im Fluidkreislauf gelenkt werden.

In einer bevorzugten Ausführungsform ist das Ventil ein Drei-Wege-Ventil, welches ausgebildet ist, den Kältemittelfluss durch den Abschnitt und/oder durch die Bypass-Fluidleitung zu leiten. Mittels des Drei-Wege-Ventils kann der Kältemittelfluss vorteilhaft von dem Abschnitt auf die Bypass-Fluidleitung umgelenkt werden. Bevorzugt ist das Drei-Wege-Ventil ein Schiebeventil, welches einen Ventileingang und einen mit dem Abschnitt verbundenen Ventilausgang und einen weiteren mit der Bypass-Fluidleitung verbundenen Ventilausgang aufweist. Das Schiebeventil weist ein bevorzugt in Abhängigkeit des Steuersignals betätigbar ausgebildetes Stellelement oder Schiebeelement auf, welches wenigstens einen Durchbruch aufweist, welcher ausgebildet ist, den Fluidstrom von dem Eingang zu der Bypass-Fluidleitung oder dem Abschnitt zu leiten, und das Stellelement dazu drehbar oder das Schiebelement dazu axial verschiebbar gelagert ist. So kann beispielsweise entlang eines Dreh- oder Schiebeweges des Schiebers der in dem Schieber beziehungsweise Stellelement angeordnete Durchbruch von einer Öffnung für den Abschnitt weggeschwenkt oder weggeschoben werden und dabei vor eine Öffnung für die Bypass-Fluidleitung - innerhalb des Drei-Wege-Ventils - bewegt werden. Bevorzugt kann so der Fluidstrom stufenlos von dem Ausgang für den Abschnitt, auf den Ausgang für die Bypass-Fluidleitung umgestellt werden. Vorteilhaft kann so bei einer mittleren Stellung des Schiebers sowohl ein Kältemittelfluss durch den Abschnitt fließen als auch durch die Bypass-Fluidleitung, bevorzugt zu gleichen Teilen in der zuvor genannten mittleren Stellung. Bevorzugt ist dabei eine Summe der Durchflüsse durch den Abschnitt und die Bypass-Fluidleitung konstant und so unabhängig von einer Stellung des Schiebers beziehungsweise Stellelements.

In einer bevorzugten Ausführungsform weist die Wärmepumpe zwei steuerbar ausgebildete Ventile auf, wobei ein Ventil ausgebildet und angeordnet ist, den Kältemittelfluss durch den Abschnitt zu öffnen oder zu schließen und ein weiteres Bypass-Ventil ausgebildet und angeordnet ist, den Kältemittelfluss durch die Bypass-Fluidleitung zu öffnen oder zu schließen. Die Steuereinheit ist mit dem Bypass-Ventil verbunden und ausgebildet, in Abhängigkeit des Temperatursignals und/oder des Feuchtigkeitssignals das Bypass-Ventil zum Öffnen anzusteuern und das Ventil zum Sperren des Abschnitts anzusteuern. So kann der Kältemittelfluss von dem die Leistungsendstufe kühlenden Abschnitt auf den Bypass umgeschaltet werden.

In einer bevorzugten Ausführungsform weist die Wärmepumpe ein Durchlassventil auf, welches ausgebildet und angeordnet ist, den Kältemittelfluss durch die Bypass-Fluidleitung in Abhängigkeit eines Fluiddruckes des Kältemittels freizugeben oder zu sperren. Bevorzugt ist das Durchlassventil in der Bypass-Fluidleitung angeordnet. So kann vorteilhaft das zuvor erwähnte steuerbar ausgebildete Ventil in der Bypass-Fluidleitung durch das passive, druckabhängig schaltende Durchlassventil ersetzt werden. Wenn beispielsweise die Steuereinheit das Steuersignal zum Sperren des Abschnitts erzeugt und an das steuerbar ausgebildete Ventil zum Sperren des Kältemittelflusses durch den die Leistungsendstufe kühlenden Abschnitt sendet, so steigt der Kältemitteldruck in dem Kältemittelkreislauf vor dem Abschnitt an, sodass sich das Durchlassventil in Abhängigkeit des Druckanstiegs öffnen kann und so der Kältemittelfluss der Wärmepumpe über den Bypass weiter aufrecht erhalten werden kann.

Erfindungsgemäß weist die Wärmepumpe einen mit der Steuereinheit verbundenen Umgebungstemperatursensor auf. Der Umgebungstemperatursensor ist ausgebildet, eine Umgebungstemperatur zu erfassen und ein die Umgebungstemperatur repräsentierendes Umgebungstemperatursignal zu erzeugen. Die Steuereinheit ist ausgebildet, das Steuersignal für das wenigstens eine Ventil derart zu erzeugen, dass die Temperatur der Leistungsendstufe größer als die Umgebungstemperatur ist. Erfindungsgemäß ist die Steuereinheit ausgebildet, die Temperatur der Leistungsendstufe um ein vorbestimmtes Temperaturintervall größer als die Umgebungstemperatur zu regeln. So kann vorteilhaft mittels der zuvor erwähnten erfassten Temperaturen das Betauen der Leistungselektronik zuverlässig verhindert werden.

In einer bevorzugten Ausführungsform ist die Steuereinheit ausgebildet, das Steuersignal derart zu erzeugen, dass der Kältemittelfluss periodisch alternierend durch den Abschnitt und durch die Bypass-Fluidleitung fließt. Dadurch können die Ventile jeweils vorteilhaft als - insbesondere aufwandsgünstig bereitzustellendes - Magnetventil ausgebildet sein, welches ausgebildet ist, in Abhängigkeit des Steuersignals einen Durchfluss vollständig freigeben oder zu sperren.

In einer anderen Ausführungsform repräsentiert das Steuersignal einen Öffnungsgrad des Ventils zwischen einer vollen Öffnung und einer gesperrten Ventilstellung, so dass mittels der Steuereinheit der Durchfluss durch beide Ventile mittels einer Regelung teilweise freigegeben sein kann.

In einer anderen Ausführungsform kann der Kältemittelfluss - mittels des zuvor erwähnten Drei-Wege-Ventils in der Ausführungsform des Schiebers - gleichzeitig durch den Abschnitt und durch die Bypass-Fluidleitung fließen. Mittels der so ausgebildeten Steuereinheit kann anstelle der Ausführungsform mit zwei Ventilen vorteilhaft mit nur einem Ventil ein Kühlmittelfluss sowohl durch den Abschnitt als auch die Bypass-Fluidleitung erzeugt werden.

In einer bevorzugten Ausführungsform ist die Steuereinheit ausgebildet, das Steuersignal derart zu erzeugen, dass der Kältemittelfluss jeweils für ein vorbestimmtes Zeitintervall alternierend durch den Abschnitt oder durch die Bypass-Fluidleitung fließt. Bevorzugt wird das Zeitintervall von einem Pulsweitenmodulator erzeugt. So kann die Wärmepumpe vorteilhaft in der Ausführungsform mit wenigstens einem Ventil oder zusätzlich dem Durchlassventil oder in der Ausführungsform mit zwei Ventilen, nämlich einem Ventil für den Abschnitt und einem weiteren Ventil für die Bypass-Fluidleitung, die Kühlleistung auf dem Abschnitt, welcher Wärme von der Leistungsendstufe abführen kann, mittels pulsweitenmodulierter Signale gesteuert werden.

Bevorzugt weist die Wärmepumpe ein Abzweigelement auf, welches eingangsseitig mit einem Verdampfer der Wärmepumpe verbunden ist und mit einem ersten Ausgang mit der Bypass-Fluidleitung und einem zweiten Ausgang mit dem Abschnitt, insbesondere Kühlkörper verbunden ist. Das Abzweigelement ist ausgebildet, den eingangsseitig empfangenen Kältemittelstrom auf den ersten und den zweiten Ausgang aufzuteilen und dort auszugeben.

Die Erfindung betrifft auch ein Verfahren zum Verhindern einer Betauung einer Leistungsendstufe einer Wärmepumpe, wobei die Leistungsendstufe über einen Kältemittelkreislauf der Wärmepumpe gekühlt wird. Ein solches Verfahren gemäß der Erfindung ist in Anspruch 8 definiert.

Bevorzugt wird bei dem Verfahren eine Temperatur der Leistungsendstufe erfasst und ein die Temperatur repräsentierendes Temperatursignal erzeugt. Weiter bevorzugt wird in Abhängigkeit des Temperatursignals ein Kältemittelfluss an der Leistungsendstufe unterbrochen oder reduziert und das Kältemittel zum Weiterbetrieb der Wärmepumpe an der Leistungsendstufe - bevorzugt durch einen Bypass - wenigstens teilweise oder vollständig vorbeigeführt.

Erfindungsgemäß wird bei dem Verfahren eine Umgebungstemperatur erfasst und ein die Umgebungstemperatur repräsentierendes Umgebungstemperatursignal erzeugt. Bevorzugt wird während des Betriebs der Wärmepumpe die Temperatur der Leistungsendstufe in Abhängigkeit des Umgebungstemperatursignals derart geregelt, dass die Temperatur der Leistungsendstufe größer ist als die Umgebungstemperatur.

Die Erfindung wird nun im Folgenden anhand von weiteren Ausführungsbeispielen beschrieben. Weitere vorteilhafte Ausführungsvarianten ergeben sich aus den in den abhängigen Ansprüchen und den Figuren beschriebenen Merkmalen.

Figur 1 zeigt ein Ausführungsbeispiel für eine Wärmepumpe, bei der ein Kältemittelkreislauf über eine Leistungselektronik umfassend einen Inverter geführt ist und beim Betrieb der Wärmepumpe Verlustwärme von dem Inverter an den Kältemittelkreislauf abgegeben werden kann. Der Kältemittelkreislauf weist eine Bypass-Fluidleitung auf, durch welche das Kältemittel mittels wenigstens eines Ventils an der Leistungselektronik vorbeigeführt werden kann, so dass eine Betauung der Leistungselektronik verhindert werden kann;

Figur 2 zeigt ein Diagramm in dem beim Betrieb der in Figur 1 dargestellten Wärmepumpe aufgezeichnete Temperaturkurven dargestellt sind;

Figur 3 zeigt ein Beispiel für ein steuerbar ausgebildetes Drei-Wege-Ventil, mit dem der Kältemittelfluss durch die Bypass-Fluidleitung und über die Leistungselektronik stufenlos eingestellt werden kann.

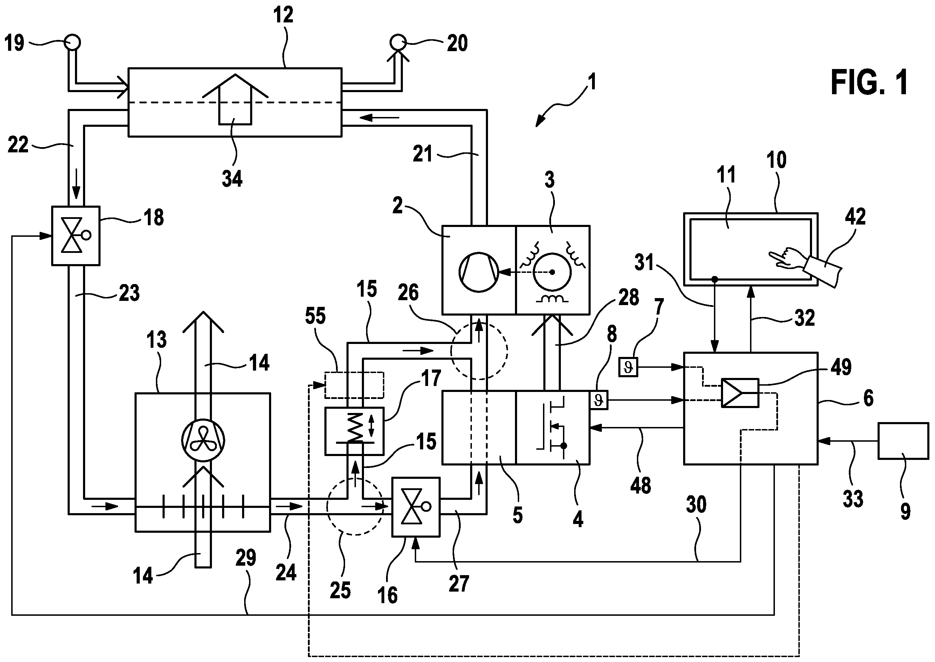

Figur 1 zeigt ein Ausführungsbeispiel für eine Wärmepumpe 1. Die Wärmepumpe 1 weist einen Verdichter 2 und einen mit dem Verdichter wirkverbundenen Elektromotor 3 auf. Der Elektromotor 3 ist eine elektronisch kommutierter Elektromotor, welcher in diesem Ausführungsbeispiel einen permanentmagnetisch ausgebildeten Rotor und einen zum Erzeugen eines magnetischen Drehfeldes ausgebildeten Stator aufweist. Der Elektromotor 3, insbesondere Statorspulen des Stators, sind mit einem Inverter 4, zuvor auch Leistungsendstufe genannt, verbunden. Der Inverter 4 weist beispielsweise Halbleiterschalter-Halbbrücken auf, wobei der Halbleiterschalter beispielsweise ein Feldeffekttransistor oder ein Insulated-Gate-Bipolar-Transistor ist.

Der Inverter 4 ist mit einem Kühlkörper 5 wärmeleitend verbunden. Der Kühlkörper 5 weist in diesem Ausführungsbeispiel wenigstens einen oder mehrere Fluidkanäle auf und ist ausgebildet, von dem Inverter 4 erzeugte Verlustwärme an ein in dem wenigstens einen Fluidkanal fließenden Kältemittel abzuführen. Der Kühlkörper 5 ist in einen Kältekreislauf der Wärmepumpe 1 eingebunden und bildet so den zuvor erwähnten Abschnitt des Kältekreislaufs.

Die Wärmepumpe 1 weist auch eine Steuereinheit 6 auf, welche beispielsweise durch einen Mikroprozessor oder einen Mikrocontroller oder ein FPGA (FPGA = Field-Programmable-Gate-Array) gebildet ist. Die Steuereinheit 6 ist eingangsseitig mit einem Umgebungstemperatursensor 7 verbunden. Der Umgebungstemperatursensor 7 ist ausgebildet, eine Temperatur einer Umgebungsluft im Bereich des Inverters 4 zu erfassen.

Die Wärmepumpe 1 weist auch einen Temperatursensor 8 auf, welcher ausgebildet und angeordnet ist, eine Temperatur des Inverters 4 oder zusätzlich der Steuereinheit 6 zu erfassen. Die Steuereinheit 6 kann beispielsweise Bestandteil einer Elektronik der Wärmepumpe 1 sein. Sowohl die Steuereinheit 6 als auch die Leistungsendstufe 4 sind elektronische Komponenten der Wärmepumpe 1, welche vor einem Feuchtigkeitsniederschlag, zuvor auch Betauung genannt, geschützt werden soll.

Die Steuereinheit 6 ist ausgangsseitig über eine Verbindungsleitung 32 mit einem Display 10 verbunden. Das Display 10 ist in diesem Ausführungsbeispiel als Touch-Screen ausgebildet und weist dazu eine berührungsempfindliche Oberfläche 11 auf, welche ausgangsseitig über eine Verbindungsleitung 31 mit der Steuereinheit 6 verbunden ist. Die berührungsempfindliche Oberfläche 11 ist ausgebildet, in Abhängigkeit eines Berührens - beispielsweise durch eine Benutzerhand 47 - ein Benutzerinteraktionssignal zu erzeugen, welches einen Berührungsort der berührungsempfindlichen Oberfläche 11 repräsentiert und dieses ausgangsseitig über die Verbindungsleitung 31 an die Steuereinheit 6 zu senden.

Das Display 10 ist beispielsweise als LCD-Display, als LED-Display oder als TFT-Display ausgebildet.

Die Wärmepumpe 1 weist auch einen Verflüssiger 12 auf, welcher in diesem Ausführungsbeispiel einen Wärmetauscher zum Transportieren von der Wärmepumpe 1 erzeugter und gepumpter Wärme 34 zu einem Heizungskreislauf hin ausgebildet ist. Der Verflüssiger 12 weist dazu einen Eingang 19 für den Heizungskreislauf und einen Ausgang 20 für den Heizungskreislauf auf. Der Verflüssiger 12 ist eingangsseitig über eine Fluidleitung 21 mit dem Verdichter 2 verbunden. Der Verflüssiger 12 ist ausgangsseitig über eine Fluidleitung 22 mit einem in diesem Ausführungsbeispiel steuerbar ausgebildeten Expansionsventil 18 verbunden. Das Expansionsventil 18 ist ausgangsseitig über eine Fluidleitung 23 mit einem Verdampfer 13 verbunden. Der Verdampfer 13 weist in diesem Ausführungsbeispiel einen Ventilator auf und ist ausgebildet, Wärme aus einem Luftstrom 14 aufzunehmen und an ein von der Fluidleitung 23 empfangenes Kältemittel abzugeben. Der Verdampfer 13 ist ausgangsseitig über eine Fluidleitung 24 mit einem Abzweigelement 25 verbunden. Das Abzweigelement 25 teilt den Kältemittelfluss von der Fluidleitung 24 kommend zu einem Bypass 15 hin und zu einem steuerbar ausgebildeten Ventil 16 hin, welches über eine Fluidleitung 27 ausgangsseitig mit dem Kühlkörper 5 verbunden ist. Der Kühlkörper 5 ist ausgangsseitig über ein Abzweigelement 26 mit dem Verdichter 2 verbunden.

Der Bypass 15 ist mit dem Abzweigelement 26 und so auch in Flussrichtung mit dem Verdichter 2 verbunden. Der Bypass 15 ist ausgebildet, einen Kältemittelfluss von dem Verdampfer 13 kommend an dem Kühlkörper 5 vorbeizuführen und dem Verdichter 2 - unter Umgehung des Kühlkörpers 5 - zuzuführen.

Die Steuereinheit 6 ist über eine Verbindungsleitung 30 mit dem steuerbar ausgebildeten Ventil 16 verbunden und ist ausgebildet, in Abhängigkeit eines von dem Temperatursensor 8 und/oder dem Umgebungstemperatursensor 7 erzeugten Temperatursignals ein Steuersignal zu erzeugen und dieses über die Verbindungsleitung 30 an das Ventil 16 zu senden. Zusätzlich oder unabhängig von den Temperatursignalen der Temperatursensoren 7 und 8 kann die Steuereinheit 6 das Steuersignal zum Betätigen des Ventils 16 in Abhängigkeit des von dem Feuchtigkeitssensor 9 erzeugten Feuchtigkeitssignal erzeugen. Der Feuchtigkeitssensor 9 ist über eine Verbindungsleitung 33 mit der Steuereinheit 6 verbunden.

Die Funktionsweise der Wärmepumpe 1 wird nun im Folgenden beschrieben:
Wenn beispielsweise mittels der Benutzerhand 47 von der berührungsempfindlichen Oberfläche 11 des Displays 10 ein Benutzerinteraktionssignal erzeugt wird, kann die Steuereinheit 6 das Benutzerinteraktionssignal über die Verbindungsleitung 31 empfangen und in Abhängigkeit des Benutzerinteraktionssignals den Inverter 4 über eine Verbindungsleitung 48 zum Bestromen des Elektromotors 3 ansteuern. Der Inverter 4 kann dann über eine elektrische Verbindung 28 den Elektromotor 3, insbesondere den Stator des Elektromotors 3, zum Erzeugen eines magnetischen Drehfeldes bestromen. Dabei erzeugt der Inverter 4 Verlustwärme. Der Verdichter 2 kann dann - angetrieben durch den Elektromotor 3 - einen Kältemittelfluss erzeugen, welcher über die Fluidleitung 21, weiter über den Verflüssiger 12, die Fluidleitung 22, das Expansionsventil 18, die Fluidleitung 23 und den Verdampfer 13, weiter über die Fluidleitung 24 und das Ventil 16, und über die Fluidleitung 27 zum Kühlkörper 5 fließt. Das Kältemittel kann vom Kühlkörper 5 schließlich über das Abzweigelement 26 zum Verdichter 2 zurückfließen. Die Steuereinheit 6 ist ausgebildet, in Abhängigkeit des Benutzerinteraktionssignals ein Steuersignal zum Öffnen des Ventils 16 über die Verbindungsleitung 30 an das Ventil 16 zu senden. Das Kältemittel fließt dann durch das geöffnete Ventil 16 über den Kühlkörper 5 zum Verdichter 2.

Nach einem Anlaufen des Verdichters 2 sinkt dabei eine Temperatur des Kühlmittels am Verdampfer 13 stark ab, sodass der mit dem Kühlkörper 5 wärmeleitend verbundene Inverter 4 beispielsweise auf eine Temperatur kleiner als eine Umgebungstemperatur abgekühlt werden kann. Die Steuereinheit 6 ist ausgebildet, in Abhängigkeit des Umgebungstemperatursensors 7 erzeugten Umgebungstemperatursignals und in Abhängigkeit des vom Temperatursensor 8 erzeugten Temperatursignals ein Differenzsignal zu erzeugen, welches eine Temperaturdifferenz der Temperatursignale repräsentiert und in Abhängigkeit des Differenzsignals das Steuersignal zum Schließen des Ventils 16 zu erzeugen und ausgangsseitig über die Verbindungsleitung 30 auszugeben. Die Steuereinheit 6 kann dazu einen Diskriminator 49 aufweisen, welcher ausgebildet ist, das Differenzsignal zu erzeugen.

Das Kältemittel fließt dann von dem Verdampfer 13 über das Abzweigelement 25 zur Bypass-Fluidleitung 15, sodass der Kältemittelkreislauf zum Verdichter 2 hin über das Abzweigelement 26 geschlossen ist.

Die Bypass-Fluidleitung 15 weist in diesem Ausführungsbeispiel ein Durchlassventil 17 auf, welches ausgebildet ist, bei einem vorbestimmten Kältemitteldruck, empfangen vom Verdampfer 13, zu öffnen und so den Bypass 15 für den Kältemittelfluss freizugeben.

In einer anderen Ausführungsform ist anstelle des Durchlassventils 17 ein weiteres steuerbar ausgebildetes Ventil 55 wie das Ventil 16 angeordnet, welches mit der Steuereinheit 6 verbunden ist. Das weitere Ventil 55 ist gestrichelt dargestellt. Die Steuereinheit 6 kann dann in Abhängigkeit des Umgebungstemperatursignals und des Temperatursignals oder des Feuchtigkeitssignals bei Unterschreiten einer vorbestimmten Temperaturdifferenz zwischen der Umgebungstemperatur und der Temperatur des Inverters 4, welche um die vorbestimmte Temperaturdifferenz größer ist als die Umgebungstemperatur, ein Steuersignal zum Öffnen des Ventils anstelle des Durchlassventils 17 und ein Steuersignal zum Schließen des Ventils 16 zum Kühlkörper 5 hin erzeugen. Die Ventile 16 und 55 können jeweils ausgebildet sein, in Abhängigkeit des Steuersignals teilweise oder vollständig zu öffnen, so dass mittels des Steuersignals, erzeugt durch die Steuereinheit 6, ein Durchfluss durch das Ventil geregelt werden kann.

In einer anderen Ausführungsform weist die Bypass-Fluidleitung 15 kein druckabhängig schaltendes Durchlassventil wie das Durchlassventil 17 oder das anstelle des Durchlassventils 17 angeordneten steuerbar ausgebildeten Ventils wie das Ventil 16 auf. Der Kältemittelfluss teilt sich dann bei geöffnetem Ventil 16 am Abzweigelement in einen Anteil, welcher durch das Ventil 16 über den Kühlkörper 5 zum Abzweigelement 26 hinfließt und welcher über das Abzweigelement 25 über den Bypass 15 zum Abzweigelement 26 fließt und sich dort mit dem vom Kühlkörper 5 kommenden Kältemittelfluss vereint und zum Verdichter 2 gelangt.

Die Abzweigelemente 25 und 26 sind beispielsweise jeweils durch ein zum Fluidführen ausgebildetes T-Stück oder Y-Stück gebildet.

Wenn die Temperatur des Inverters, erfasst durch den Temperatursensor 8, weiter ansteigt, kann die Steuereinheit 6 ein Steuersignal zum wenigstens teilweisen oder vollständigen Öffnen des Ventils 16 erzeugen, sodass der Inverter 4 über den Kühlkörper 5 Verlustwärme an das Kältemittel abgeben kann. So kann vorteilhaft ein Wirkungsgrad der Wärmepumpe 1 vergrößert werden, insoweit die vom Inverter 4 erzeugte Verlustwärme nicht an eine Umgebung, sondern als Bestandteil der von der Wärmepumpe 1 gepumpten Wärme 34 an den Heizungskreislauf abgegeben werden kann.

Die Steuereinheit 6 ist über eine Verbindungsleitung 29 mit dem in diesem Ausführungsbeispiel steuerbar ausgebildeten Expansionsventil 18 verbunden und kann eine Leistung der Wärmepumpe 1, insbesondere die Wärmeleistung der gepumpten Wärme 34 über das steuerbar ausgebildete Expansionsventil 18 regeln und dazu ein entsprechendes Steuersignal - beispielsweise in Abhängigkeit eines vom Display 10 empfangenen Benutzerinteraktionssignal erzeugen und an das Expansionsventil 18 senden.

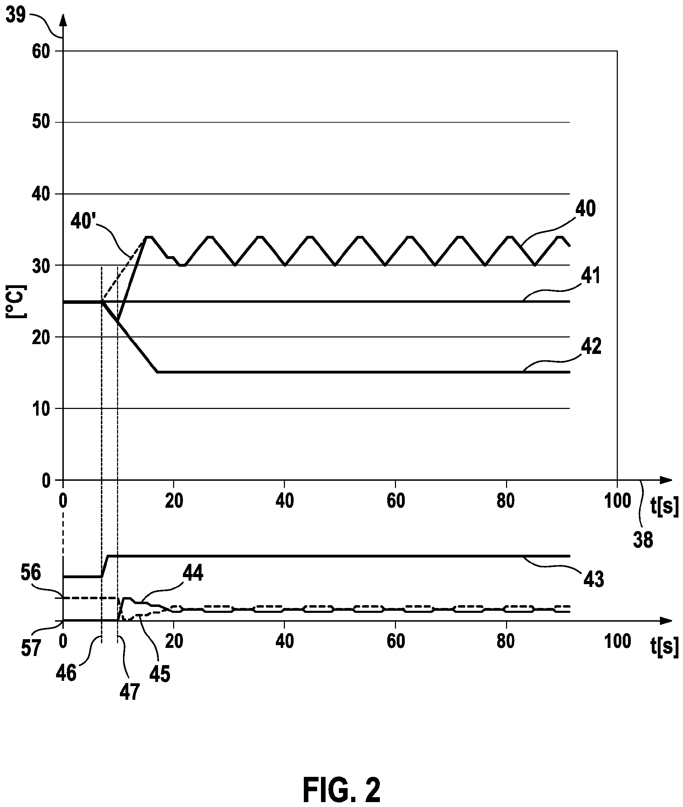

Figur 2 zeigt ein Diagramm, welches eine Zeitachse 38 und eine Amplitudenachse 39 aufweist. Die Amplitudenachse 39 repräsentiert eine Temperatur in Grad Celsius für eine Kurve 40, eine Kurve 41 und eine Kurve 42. Die Kurve 40 repräsentiert eine Temperatur des Inverters 4, beispielsweise repräsentiert durch das durch den Temperatursensor 8 in Figur 1 erzeugte Temperatursignal. Die Kurve 41 repräsentiert ein Umgebungstemperatursignal, erzeugt durch den Umgebungstemperatursensor 7 in Figur 1. Die Temperatur 42 repräsentiert eine Temperatur des Kältemittels.

Dargestellt ist auch eine Kurve 43, welche einen Ein- beziehungsweise Ausschaltzustand des in Figur 1 dargestellten Elektromotors 3 und so auch des Verdichters 2 repräsentiert. Dargestellt ist auch eine Kurve 44, welche einen Kältemittelfluss durch die Bypass-Fluidleitung 15 in Figur 1 repräsentiert. Eine Kurve 45 repräsentiert einen Kältemittelfluss durch die Fluidleitung 27, gesteuert durch das Ventil 16.

Der Kältemittelfluss durch die Bypass-Fluidleitung 15, repräsentiert durch die Kurve 44, wird in dem in Figur 2 dargestellten Beispiel durch ein steuerbar ausgebildetes Ventil erzeugt, welches anstelle des Durchlassventils 17 in Figur 1 in der Bypass-Fluidleitung 15 angeordnet ist.

Zu einem Zeitpunkt 46 wird von der Steuereinheit 6 der Inverter 4 über die Verbindungsleitung 48 - beispielsweise mittels Steuerpulsen zum Erzeugen eines magnetischen Drehfelds im Elektromotor 3 - angesteuert. Sichtbar ist, dass die Temperatur des Kältemittels, repräsentiert durch die Kurve 42, absinkt. Wenn die Temperatur des Inverters, repräsentiert durch die Kurve 40, nach dem Zeitpunkt 46 um eine vorbestimmte Temperaturdifferenz kleiner ist als zum Zeitpunkt 46, so wird zu einem Zeitpunkt 47 das Steuersignal zum Öffnen des Ventils 55 anstelle des Ventils 17 in Figur 1 und das Steuersignal zum Schließen des Ventils 16 erzeugt.

In einer anderen Ausführungsform wird das Ventil 16 zum Zeitpunkt 46 zum Schließen angesteuert, so dass eine Temperatur des Inverters 4 nicht unter die Umgebungstemperatur fallen kann. Das ist durch die gestrichtelte Kurve 40' dargestellt.

Die Steuereinheit 6 regelt dann im folgenden Zeitverlauf die Temperatur des Inverters derart, dass die Temperatur des Inverters größer ist als eine Umgebungstemperatur, erfasst durch den Umgebungstemperatursensor 7 in Figur 1.

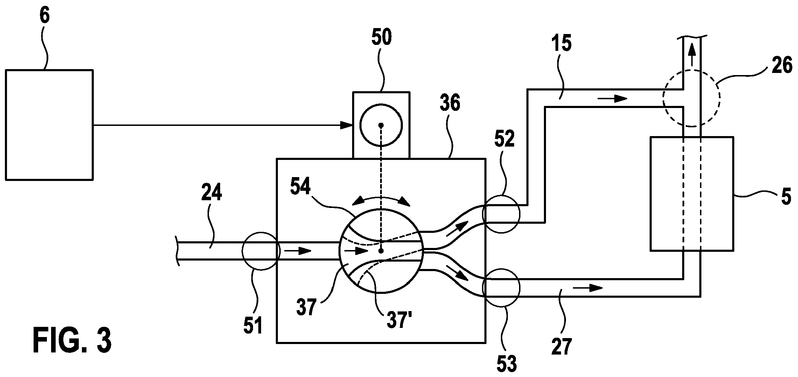

Figur 3 zeigt ein Ausführungsbeispiel für ein Drei-Wege-Ventil, welches anstelle des in Figur 1 dargestellten Abzweigelements 25 angeordnet sein kann.

Das Drei-Wege-Ventil 36 weist einen Eingang 51, einen Ausgang 52 und einen Ausgang 53 auf.

Der Eingang 51 ist mit der in Figur 1 dargestellten Fluidleitung 24 verbunden, wobei der Ausgang 52 mit dem Bypass 15 verbunden ist.

Der Bypass 15 ist mit dem Abzweigelement 26 verbunden, wo ein von dem Kühlelement 5 empfangener Kältemittelfluss mit einem von der Bypass-Fluidleitung 15 empfangenen Kältemittelfluss zusammengeführt und an den Verdichter 2 geleitet wird.

Das Drei-Wege-Ventil 36 weist ein - beispielsweise in Abhängigkeit eines von der in Figur 1 dargestellten Steuereinheit 6 erzeugten Steuersignal - steuerbar ausgebildetes Stellelement 54 auf. Das Stellelement 54 ist in diesem Ausführungsbeispiel drehbar gelagert und weist einen sich verjüngenden Fluidkanal 37 auf, welcher ausgebildet ist, vom Eingang 51 empfangenes Kältemittel in Abhängigkeit einer Drehstellung des Drehelements zum Ausgang 52 und/oder zum Ausgang 53 zu leiten. Das Stellelement 54 nimmt in der in Figur 3 dargestellten Position eine Mittelstellung ein, sodass der Kältemittelfluss auf die Ausgänge 52 und 53 zu gleichen Teilen aufgeteilt wird. Dargestellt ist auch eine Schwenkstellung 37', in der der Eingang 51 nur mit dem Ausgang 52 verbunden ist, sodass der Kältemittelfluss nur über den Bypass 15 am Kühlkörper 5 vorbeigeleitet werden kann. Das Drei-Wege-Ventil 36, insbesondere das Stellelement 54, ist mit einem Stellmotor 50 verbunden, welcher ausgebildet ist, eine Winkelstellung des Stellelements 54 in Abhängigkeit eines eingangsseitig empfangenen Steuersignals zu ändern und in einer geänderten Position festzustellen. Das Steuersignal kann beispielsweise von der in Figur 1 gezeigten Steuereinheit 6 in Abhängigkeit des Temperatursignals und/oder Feuchtigkeitssignals erzeugt werden.

## Patentansprüche

1. Wärmepumpe (1) mit einem Verdichter (2), und einem mit dem Verdichter (2) verbundenen elektronisch kommutierten Elektromotor zum Antrieb des Verdichters, wobei die Wärmepumpe eine mit dem Elektromotor verbundene Leistungsendstufe (4) aufweist, welche ausgebildet ist, den Elektromotor zu bestromen, und die Leistungsendstufe (7) mit einem Abschnitt (5) eines Kältemittelkreislaufs (5, 21, 22, 23, 24, 27) der Wärmepumpe (1) wärmeleitend verbunden ist, so dass von der Leistungsendstufe (4) erzeugte Verlustwärme an den Kältemittelkreislauf (5, 21, 22, 23, 24, 27) abgegeben werden kann, wobei die Wärmepumpe (1) wenigstens einen Temperatursensor (8) aufweist, wobei der Temperatursensor (8) angeordnet ist, eine Temperatur der Leistungsendstufe (4) zu erfassen und ein die Temperatur repräsentierendes Temperatursignal zu erzeugen, wobei der Kältemittelkreislauf (21, 22, 23, 24, 27) eine Bypass-Fluidleitung (15) und wenigstens ein steuerbar ausgebildetes Ventil (16, 36, 55) aufweist, wobei die Bypass-Fluidleitung (15) ausgebildet und angeordnet ist, einen Kältemittelfluß an dem Abschnitt (5) vorbeizuführen und das Ventil (16, 36, 55) ausgebildet ist, in Abhängigkeit eines Steuersignals den Kältemittelfluß durch den Abschnitt (5) freizugeben oder zu sperren, und die Wärmepumpe (1) eine mit dem Temperatursensor (8) verbundene Steuereinheit (6) aufweist, welche ausgebildet ist, das Steuersignal in Abhängigkeit des Temperatursignals zu erzeugen.
**dadurch gekennzeichnet, dass**
die Wärmepumpe (1) einen mit der Steuereinheit (6) verbundenen Umgebungstemperatursensor (7) aufweist, welcher ausgebildet ist eine Umgebungstemperatur zu erfassen und ein die Umgebungstemperatur repräsentierendes Umgebungstemperatursignal zu erzeugen und die Steuereinheit (6) ausgebildet ist, das Steuersignal derart zu erzeugen, dass die Temperatur der Leistungsendstufe (4) größer als die Umgebungstemperatur ist.

2. Wärmepumpe (1) nach Anspruch 1,
**dadurch gekennzeichnet, dass**
das Ventil (16, 17, 36, 55) ein Magnetventil ist, welches einen elektromagnetisch bewegbar ausgebildeten Anker aufweist, welcher ausgebildet ist, in Abhängigkeit des Steuersignals den Kältemittelkreislauf zu unterbrechen und/oder freizugeben.

3. Wärmepumpe (1) nach Anspruch 1 oder 2,
**dadurch gekennzeichnet, dass**
das Ventil ein 3-Wege-Ventil (36) ist, welches ausgebildet ist, den Kältemittelfluß durch den Abschnitt (5) und/oder die Bypass-Fluidleitung (15) zu leiten.

4. Wärmepumpe (1) nach Anspruch 1 oder 2,
**dadurch gekennzeichnet, dass**
die Wärmepumpe (1) zwei steuerbar ausgebildete Ventile (16) aufweist, wobei ein Ventil (16) ausgebildet und angeordnet ist, den Kältemittelfluß durch den Abschnitt zu öffnen oder zu schließen, und ein weiteres Ventil (55) ausgebildet und angeordnet ist, den Kältemittelfluß durch die Bypass-Fluidleitung (15) zu öffnen oder zu schließen, wobei die Steuereinheit (6) mit dem weiteren Ventil (55) verbunden und ausgebildet ist, in Abhängigkeit des Temperatursignals das weitere Ventil (55) zum Öffnen anzusteuern und das Ventil (16) zum Sperren des Abschnitts (5) anzusteuern.

5. Wärmepumpe (1) nach Anspruch 1 oder 2,
**dadurch gekennzeichnet, dass**
die Wärmepumpe (1) ein Durchlassventil (17) aufweist, welches ausgebildet und angeordnet ist, den Kältemittelfluß durch die Bypass-Fluidleitung (15) in Abhängigkeit eines Fluiddruckes des Kältemittels freizugeben oder zu sperren.

6. Wärmepumpe (1) nach einem der vorhergehenden Ansprüche,
**dadurch gekennzeichnet, dass**
die Steuereinheit (6) ausgebildet ist, das Steuersignal derart zu erzeugen, dass der Kältemittelfluß alternierend durch den Abschnitt (5) und durch die Bypass-Fluidleitung (15) fließt.

7. Wärmepumpe (1) nach Anspruch 6,
**dadurch gekennzeichnet, dass**
die Steuereinheit (6) ausgebildet ist, das Steuersignal derart zu erzeugen, dass der Kältemittelfluß jeweils für ein vorbestimmtes Zeitintervall alternierend durch den Abschnitt (5) und durch die Bypass-Fluidleitung (15) fließt.

8. Verfahren zum Verhindern einer Betauung einer Leistungsendstufe (4) einer Wärmepumpe (1), wobei die Leistungsendstufe (4) über einen Kältemittelkreislauf (5, 21, 22, 23, 24, 27) der Wärmepumpe (1) gekühlt wird, wobei eine Temperatur der Leistungsendstufe (4) erfasst wird, ein die Temperatur repräsentierendes Temperatursignal (40) erzeugt wird und in Abhängigkeit des Temperatursignals ein Kältemittelfluß an der Leistungsendstufe (4) unterbrochen oder reduziert wird, und das Kältemittel zum Weiterbetrieb der Wärmepumpe (1) an der Leistungsendstufe (4) wenigstens teilweise oder vollständig vorbeigeführt wird.
**dadurch gekennzeichnet, dass**
eine Umgebungstemperatur erfasst wird und ein die Umgebungstemperatur repräsentierendes Umgebungstemperatursignal (41) erzeugt wird und während des Betriebs der Wärmepumpe (1) die Temperatur der Leistungsendstufe (4) in Abhängigkeit des Umgebungstemperatursignals (41) derart geregelt wird, dass die Temperatur der Leistungsendstufe (4) größer ist als die Umgebungstemperatur.

## Claims

1. Heat pump (1) comprising a compressor (2) and an electronically commutated electric motor, which is connected to the compressor (2), for driving the compressor, wherein the heat pump has a power output stage (4) which is connected to the electric motor and is designed to energize the electric motor, and the power output stage (7) is thermally conductively connected to a section (5) of a coolant circuit (5, 21, 22, 23, 24, 27) of the heat pump (1), so that waste heat which is generated by the power output stage (4) can be given off to the coolant circuit (5, 21, 22, 23, 24, 27), wherein the heat pump (1) has at least one temperature sensor (8), wherein the temperature sensor (8) is arranged to detect a temperature of the power output stage (4) and to generate a temperature signal which represents the temperature, wherein the coolant circuit (21, 22, 23, 24, 27) has a bypass fluid line (15) and at least one valve (16, 36, 55) of controllable design, wherein the bypass fluid line (15) is designed and arranged to conduct a coolant flow past the section (5) and the valve (16, 36, 55) is designed to release or to block the coolant flow through the section (5) depending on a control signal, and the heat pump (1) has a control unit (6) which is connected to the temperature sensor (8) and is designed to generate the control signal depending on the temperature signal,
**characterized in that**
the heat pump (1) has an ambient temperature sensor (7) which is connected to the control unit (6) and is designed to detect an ambient temperature and to generate an ambient temperature signal which represents the ambient temperature and the control unit (6) is designed to generate the control signal in such a way that the temperature of the power output stage (4) is greater than the ambient temperature.

2. Heat pump (1) according to Claim 1,
**characterized in that**
the valve (16, 17, 36, 55) is a solenoid valve which has an armature which is designed in an electromagnetically movable manner and is designed to interrupt and/or to release the coolant circuit depending on the control signal.

3. Heat pump (1) according to Claim 1 or 2,
**characterized in that**
the valve is a 3-way valve (36) which is designed to direct the coolant flow through the section (5) and/or the bypass fluid line (15).

4. Heat pump (1) according to Claim 1 or 2,
**characterized in that**
the heat pump (1) has two valves (16) of controllable design, wherein one valve (16) is designed and arranged to open or to close the coolant flow through the section, and a further valve (55) is designed and arranged to open or to close the coolant flow through the bypass fluid line (15), wherein the control unit (6) is connected to the further valve (55) and designed to actuate the further valve (55) for opening and to actuate the valve (16) for blocking the section (5) depending on the temperature signal.

5. Heat pump (1) according to Claim 1 or 2,
**characterized in that**
the heat pump (1) has a gate valve (17) which is designed and arranged to release or to block the coolant flow through the bypass fluid line (15) depending on a fluid pressure of the coolant.

6. Heat pump (1) according to one of the preceding claims,
**characterized in that**
the control unit (6) is designed to generate the control signal in such a way that the coolant flow flows alternately through the section (5) and through the bypass fluid line (15).

7. Heat pump (1) according to Claim 6,
**characterized in that**
the control unit (6) is designed to generate the control signal in such a way that the coolant flow flows alternately through the section (5) and through the bypass fluid line (15) for a predetermined time interval in each case.

8. Method for preventing the formation of condensation on a power output stage (4) of a heat pump (1), wherein the power output stage (4) is cooled by means of a coolant circuit (5, 21, 22, 23, 24, 27) of the heat pump (1), wherein a temperature of the power output stage (4) is detected, a temperature signal (40) which represents the temperature is generated and a coolant flow at the power output stage (4) is interrupted or reduced depending on the temperature signal, and the coolant is at least partially or entirely conducted past the power output stage (4) for further operation of the heat pump (1),
**characterized in that**
an ambient temperature is detected and an ambient temperature signal (41) which represents the ambient temperature is generated and, during operation of the heat pump (1), the temperature of the power output stage (4) is regulated depending on the ambient temperature signal (41) in such a way that the temperature of the power output stage (4) is greater than the ambient temperature.

## Revendications

1. Pompe à chaleur (1) dotée d'un compresseur (2), et d'un moteur électrique à commutation électronique relié au compresseur (2) pour l'entraînement du compresseur, dans laquelle la pompe à chaleur comporte un étage final de puissance (4) qui est relié au moteur électrique et qui est conçu pour alimenter en courant le moteur électrique, et l'étage final de puissance (7) est relié de manière thermiquement conductrice à une partie (5) d'un circuit de frigorigène (5, 21, 22, 23, 24, 27) de la pompe à chaleur (1), de telle manière que les pertes de chaleur engendrées par l'étage final de puissance (4) puissent être évacuées vers le circuit de frigorigène (5, 21, 22, 23, 24, 27), dans laquelle la pompe à chaleur (1) comporte au moins un capteur de température (8), dans laquelle le capteur de température (8) est conçu pour détecter une température de l'étage final de puissance (4) et pour générer un signal de température représentant la température, dans laquelle le circuit de frigorigène (21, 22, 23, 24, 27) comporte une conduite de fluide de dérivation (15) et au moins une vanne pouvant être commandée (16, 36, 55), dans laquelle la conduite de fluide de dérivation (15) est conçue et agencée pour acheminer un flux de frigorigène vers la partie (5) et la vanne (16, 36, 55) est conçue pour libérer ou bloquer le flux de frigorigène à travers la partie (5) en fonction d'un signal de commande, et la pompe à chaleur (1) comporte une unité de commande (6) reliée au capteur de température (8) qui est conçue pour générer le signal de commande en fonction du signal de température,
**caractérisée en ce que**
la pompe à chaleur (1) comporte un capteur de température ambiante (7) relié à l'unité de commande (6), qui est conçu pour détecter une température ambiante et pour générer un signal de température ambiante représentant la température ambiante, et l'unité de commande (6) est conçue pour générer le signal de commande de telle manière que la température de l'étage final de puissance (4) soit supérieure à la température ambiante.

2. Pompe à chaleur (1) selon la revendication 1, **caractérisée en ce que** la vanne (16, 17, 36, 55) est une électrovanne qui possède une armature mobile électromagnétiquement conçue pour interrompre et/ou libérer le circuit de frigorigène en fonction du signal de commande.

3. Pompe à chaleur (1) selon la revendication 1 ou 2, **caractérisée en ce que** la vanne est une vanne à trois voies (36) qui est conçue pour diriger le flux de frigorigène à travers la partie (5) et/ou la conduite de fluide de dérivation (15).

4. Pompe à chaleur (1) selon la revendication 1 ou 2, **caractérisée en ce que** la pompe à chaleur (1) comporte deux vannes (16) pouvant être commandées, dans laquelle une vanne (16) est conçue et agencée pour ouvrir ou fermer l'écoulement de frigorigène à travers ladite partie et une autre vanne (55) est conçue et agencée pour ouvrir ou fermer le flux de frigorigène à travers la conduite de fluide de dérivation (15), dans laquelle l'unité de commande (6) est reliée à l'autre vanne (55) et est conçue pour commander l'autre vanne (55) afin de ouvrir la partie (5) et pour commander la vanne (16) afin de la bloquer en fonction du signal de température.

5. Pompe à chaleur (1) selon la revendication 1 ou 2, **caractérisée en ce que** la pompe à chaleur (1) comporte une vanne de traversée (17) qui est conçue et agencée pour libérer ou bloquer l'écoulement de frigorigène à travers la conduite de fluide de dérivation (15) en fonction d'une pression de fluide du frigorigène.

6. Pompe à chaleur (1) selon l'une des revendications précédentes,
**caractérisée en ce que** l'unité de commande (6) est conçue pour générer le signal de commande de telle manière que le flux de frigorigène circule alternativement dans la partie (5) et dans la conduite de fluide de dérivation (15) .

7. Pompe à chaleur (1) selon la revendication 6,
**caractérisée en ce que** l'unité de commande (6) est conçue pour générer le signal de commande de telle manière que le flux de frigorigène circule alternativement dans la partie (5) et dans la conduite de fluide de dérivation (15) pendant un intervalle de temps prédéterminé.

8. Procédé pour éviter une condensation sur un étage final de puissance (4) d'une pompe à chaleur (1), dans lequel l'étage final de puissance (4) est refroidi par un circuit de frigorigène (5, 21, 22, 23, 24, 27) de la pompe à chaleur (1), dans lequel une température de l'étage final de puissance (4) est détectée, un signal de température (40) représentant la température est généré et un flux de frigorigène vers l'étage final de puissance (4) est interrompu ou réduit en fonction du signal de température,
et le frigorigène nécessaire à la poursuite du fonctionnement de la pompe à chaleur (1) est au moins partiellement ou totalement acheminé vers l'étage final de puissance (4),
**caractérisé en ce qu'**une température ambiante est détectée et un signal de température ambiante (41) représentant la température ambiante est généré et **en ce que**, pendant le fonctionnement de la pompe à chaleur (1), la température de l'étage final de puissance (4) est régulée en fonction du signal de température ambiante (41) de telle manière que la température de l'étage final de puissance (4) soit supérieure à la température ambiante.
